Europäisches Patentamt

European Patent Office

Office européen des brevets

(11) Publication number: **0 423 884 A1**

# EUROPEAN PATENT APPLICATION

(21) Application number: 90202711.9

(22) Date of filing: 12.10.90

(51) Int. Cl.⁵: **C23C 16/34**, C03C 17/22

(30) Priority: 16.10.89 US 421862

(43) Date of publication of application:
24.04.91 Bulletin 91/17

(84) Designated Contracting States:
DE FR GB IT NL

(71) Applicant: N.V. Philips' Gloeilampenfabrieken
Groenewoudseweg 1
NL-5621 BA Eindhoven(NL)

(72) Inventor: Vankatesan, Mahalingam
c/o INT. OCTROOIBUREAU B.V., Prof.
Holstlaan 6
NL-5656 AA Eindhoven(NL)

(74) Representative: Rensen, Jan Geert et al
Internationaal Octrooibureau B.V. Prof.
Holstlaan 6
NL-5656 AA Eindhoven(NL)

(54) Method for deposition of silicon nitride layers on glass substrates.

(57) Silicon nitride layers are deposited on glass substrates, particularly low sodium containing glass substrates, by a LPCVD system in which glass substrate is heated to a temperature below its annealing point, but above 580° C, while being exposed, in a vacuum, to a flow of ammonia and dichlorosilane at a rate of 1cc/sec/10cc/sec and in which the ratio of the flow of the ammonia to that of the dichlorosilane is 6:1 - 2:1--.

EP 0 423 884 A1

## METHOD FOR DEPOSITION OF SILICON NITRIDE LAYERS ON GLASS SUBSTRATES.

The invention relates to an improved method for providing silicon nitride barrier layers on glass substrates particularly for use in thin film transistors (hereinafter termed "TFTs"). The use of silicon nitride as a barrier for sodium has found extensive use in semiconductor technology. Such a use of silicon nitride layers is described in W. Kern and V.S. Ban "Chemical Vapor Deposition of Inorganic Films", in Thin Film Processes J. Vossen and W. Kern, Eds., Academic, 1978.

The silicon nitride layers may be deposited in different ways including low pressure chemical vapor deposition (LPCVD), plasma assisted chemical vapor deposition (PECVD) and ion-beam sputtering. Silicon nitride films of excellent uniformity may be produced by the use of LPCVD processes or PECVD processes.

In the conventional method of forming the silicon nitride barrier layers the PECVD process is employed. In this process deposition of the silicon nitride layer is usually performed after the device has been completely fabricated and generally must be done at temperatures below 400°C.

However, the PECVD process has been found to have certain disadvantages when used to form silicon nitride layers on glass substrates employed in the production of TFTs. In this technology the formation of the silicon nitride film is a first step employed in order to prevent sodium migration from the glass during the processing of the device. It is therefore required that the silicon nitride layer film be stable under the subsequent processing steps.

However, it is found that silicon nitride layers deposited by the PECVD process has certain disadvantages. These films exhibit poor stability at temperatures above 400°C, a high hydrogen content, a non-stoichiometric composition and high etch rates (comparable to silicon dioxide) when buffered HF is employed as an etchant.

In addition, PECVD deposited silicon nitride layers have a yellow color. As a result PECVD deposited silicon nitride layers are undesired for use in transmissive display applications.

Silicon nitride layers deposited by the LPCVD process do not have these disadvantages and are also colorless. However, the LPCVD process has a disadvantage in that it requires the use of temperatures which are generally higher than the temperature at which the low-sodium glasses that are commercially available and are generally used as substrates soften or are distorted.

Goldman et al, U.S. Patent 4,279,947 shows the LPCVD deposition of silicon nitride on various substrates by exposing major surfaces of substrates to a flow of a mixture of dichlorosilane and ammonia in a vacuum while being heated to a temperature of above 650°C. In the process disclosed in this patent, the only substrates employed are silicon wafers. In the employed gas, the molar ratio of ammonia to that of the dichlorosilane may be from 1:1 to 500:1. In only specific example disclosed the molar ratio ammonia to dichlorosilane in the gas employed is 12:1.

However, the method disclosed in this patent is not applicable to the formation of silicon nitride layers on low-sodium glass substrates particularly since many of these have strain and annealing points lower than 650°C, the lowest deposition temperature employed in the method disclosed in this patent.

It is a principal object of this invention to provide a LPCVD system for the deposition of silicon nitride on glass substrates, particularly low sodium containing substrates that may be carried out at temperatures below about the annealing points of the glass substrate while providing an adequate rate of deposition of the silicon nitride.

According to the method of the invention these results are achieved by heating a glass substrate to a temperature of at least 580°C but below the annealing point of said substrate and exposing the surface of said substrate, while thus heated and in a vacuum, to a flow of a mixture of ammonia and dichlorosilane at the rate of 1cc/sec - 10cc/sec and in which the ratio of the rate of flow of the ammonia to that of the dichlorosilane is 6:1 - 2:1.

While the method of the invention is applicable to the deposition of silicon nitride layers on any glass substrate it is particularly useful for the deposition upon glass substrates having an annealing point of at least 580°C and, also preferably, a sodium content of not greater than 0.1% by weight. A specific example of the preferred glasses is Corning 7059, which has a annealing point of about 639°C and a alkali content of about 0.3% by weight. Another example of a preferred glass is Hoya NA-40 which has a annealing point of about 730°C and a alkali content of about 0.1% by weight.

Preferably the glass substrate is heated to a temperature of about 580°C - 650°C.

While any rate of flow of the gas within the above-indicated range may be employed, it has been found that most desirable results have been achieved when the total flow of the dichlorosilane and ammonia is 1-4cc/sec.

Particularly good results are found to result when the flow of the gaseous mixture of dichlorosilane and ammonia is about 2cc/sec and the ratio, by rate of flow, of the ammonia to dichlorosilane is in the gaseous mixture is 2:1. Under these conditions, deposition rate of about 2.4A°/minutes of a silicon nitride film of good stoichiometry and excellent uniformity may be achieved upon a glass substrate heated to 650°C.

Example

A wafer of Corning 7059 glass was positioned in a reaction chamber as described in Goldman et al, United States Patent 4,279,947, the contents of which are hereby incorporated by reference. The glass wafer was heated to about 650°C, the reaction chamber was purged with nitrogen and the gas content of the reactive chamber was reduced to less than 600mTorr.

A gas flow of a gaseous mixture of dichlorosilane and ammonia was then flowed pass the major surfaces of the glass wafer at a rate of about 2cc/sec with the flow of the dichlorosilane being about 0.7cc/sec and that of the ammonia being about 1.4cc/sec.

A deposition rate of silicon nitride of 2,40A°/minute was achieved.

After about 90 minutes the glass wafer was allowed to cool to room temperature and removed from the reactive chamber.

A uniform 200A° thick layer of silicon nitride was found to have been formed on a major surface of the glass wafer.

Auger and electrical tests showed that the composition of the layer was essentially uniformly silicon nitride.

Claims

1. A method for the formation of a sodium barrier layer of silicon nitride on a glass substrate, characterized in that said method comprises:
heating said substrate to a temperature of at least 580°C but below the annealing point of said substrate, and
subjecting a major surface of said heated substrate, while in vacuum, to the flow of a gaseous mixture of dichlorosilane and ammonia at the rate of 1cc/sec - 10cc/sec and in which the ratio by rate of flow, of ammonia to dichlorosilane is 6:1 - 2:1.
2. The method of Claim 1 characterized in that the gass substrate has an annealing point of at least 580°C.
3. The method of Claim 2 characterized in that the glass substrate is a low sodium glass containing less than 0.1% by weight of sodium.
4. The method of Claim 3 characterized in that the flow of the gaseous mixture is 1-4cc/sec.

5. The method of Claim 4 characterized in that the glass substrate is heated to about 580°C - 650°C.
6. The method of Claim 5 characterized in that the glass substrate is heated to about 650°C, the rate of flow of the gaseous mixture is 2cc/sec and the ratio of flow of the ammonia to that of the dichlorosilane is 2:1.

European
Patent Office

EUROPEAN SEARCH
REPORT

Application Number

EP 90 20 2711

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-4 402 997 (R.H. HOGAN et al.)<br>* Whole document *<br>- - - | 1-6 | C 23<br>C 16/34<br>C 03 C 17/22 |
| A | JOURNAL OF THE ELECTROCHEMICAL SOCIETY, vol. 132, no. 12, December 1985, pages 3001-3005, Manchester, NH, US; P. PAN et al.: "The composition and physical properties of LPCVD silicon nitride deposited with different NH3/SiH2Cl2 gas ratios"<br>* Page 3001, column 2 *<br>- - - | 1-6 | |
| A | JOURNAL OF THE ELECTROCHEMICAL SOCIETY, vol. 130, no. 2, February 1983, pages 450-455, Manchester, NH, US; T. MAKINO: "Composition and structure control by source gas ratio in LPCVD SiNx"<br>* Whole document *<br>- - - | 1-6 | |
| A | US-A-4 395 438 (P.W. CHIANG)<br>* Whole document *<br>- - - | 1-6 | |
| A | CERAMIC INTERNATIONAL, vol. 15, no. 2, February 1989, page 65, Barking, GB; A. KWATERA: "Thin CVD layers of carbon-doped silicon nitride on quartz glass"<br>* Whole document *<br>- - - - - | 1 | TECHNICAL FIELDS SEARCHED (Int. Cl.5)<br><br>C 23 C<br>C 03 C |

The present search report has been drawn up for all claims

| Place of search | Date of completion of search | Examiner |
|---|---|---|
| The Hague | 14 December 90 | JOFFREAU P.O. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document